# EUROPEAN PATENT APPLICATION

(11) **EP 4 122 748 A1**
(43) Date of publication of application: **25.01.2023**
(21) Application number: 21186362.6
(22) Date of filing: 19.07.2021
(51) Int. Cl.: B60L 53/12, B60L 53/35, B60L 53/34

(54) **A METHOD FOR ORIENTING A POWER RECEIVING COIL RELATIVE TO A POWER EMITTING COIL OF A WIRELESS CHARGING SYSTEM FOR A VEHICLE**

(71) Applicant: VOLVO TRUCK CORPORATION, 405 08 Göteborg (SE)
(72) Inventor: ÖHMAN, Mikaela, 414 81 GÖTEBORG (SE); RUNDSTRÖM, Håkan, 459 91 LJUNGSKILE (SE)
(74) Representative: Kransell & Wennborg KB

(57) **Abstract**

The present invention relates to a method for orienting a power receiving coil of a vehicle relative to a power emitting coil of a wireless charging system for a vehicle. The method comprises:
- detecting a positioning of the vehicle at a charging location in which the power receiving coil detects reception of electromagnetic radiation emitted from the power emitting coil,
- performing a calibration sequence in which the orientation of the power receiving coil and/or the power emitting coil is varied according to a predetermined scheme, while registering the electromagnetic radiation reception of the power receiving coil,
- in response to the calibrations sequence, determining a desired relative orientation including relative angle between the power receiving coil and the power emitting coil for which the electromagnetic radiation reception of the power receiving coil is in a top range of the registered electromagnetic radiation reception.

## Description

### TECHNICAL FIELD

The present invention relates to a method for orienting a power receiving coil of a vehicle relative to a power emitting coil of a wireless charging system for a vehicle. The invention further relates to a wireless power supply device for a vehicle, to a wireless charging system for a vehicle, and to a vehicle.

### BACKGROUND

A vehicle typically comprises an engine or machine for propelling the vehicle. The engine may be powered by various means, such as e.g. by a liquid or gaseous fuel in an internal combustion engine, or by electric power to an electric machine. Moreover, hybrid solutions exist in which e.g. the vehicle is propelled both by an internal combustion engine and an electric machine. In either way, an energy storage device is used to store the energy needed in order to propel the vehicle. Energy storage devices may further be used to power auxiliary loads in the vehicle.

For many vehicles, the energy storage devices are comprised in an energy storage system, wherein the energy storage system is configured to power the engine or machine for propelling the vehicle, as well as an auxiliary load. For example, for an electric vehicle the energy storage system may be a rechargeable energy storage system, RESS, comprising energy storage devices being batteries which are configured to operate the electric machine as well as electrically driven auxiliary equipment (auxiliary load). The batteries are periodically in need of charging, and is then electrically connected to an electrical energy source, such as a grid or power grid.

One common solution to charge the batteries is by a plug connected to a power source, such as e.g. a power grid, by an electrical wire. Typically, the vehicle is parked in a parking/charging spot providing such charging means, and the driver or other person manually plug the charging means into a socket of the vehicle, the socket being in electrical communication with the battery enabling charging of the same.

Another solution to charge the batteries is by a wireless charging system. By using such system, the wired solution with a plug and socket can be omitted. The wireless charging system typically includes a charging station having a power emitting coil, or transmission coil, configured to emit electromagnetic radiation. The wireless system further comprises a power receiving coil configured to receive the emitted electromagnetic radiation. The power receiving coil is most often arranged on the vehicle (on-board), and the power emitting coil is most often arranged on the ground or foundation of the charging station or parking/charging spot (off-board).

Such wireless systems may include a positioning mechanism as a part of the charging station for bringing the power emitting coil into a charging distance of the power receiving coil on the vehicle, after the vehicle has been parked at the parking/charging spot. However, even though such positioning mechanism enables the batteries to be charged, regardless if the vehicle is parked in a position in which the power receiving coil initially is too far away from the power emitting coil or not, it does not provide a system enabling an optimal charging under the given conditions.

Thus, there is a need in the industry for an improved method to charge the energy storage devices or batteries of the vehicle.

### SUMMARY

It is an object of the present disclosure to at least to some extent alleviate the shortcomings discussed above in relation to known positioning mechanisms, and to improve the positioning of the wireless charging system related to charging of the energy storage devices or batteries of the vehicle.

According to at least a first aspect of the present invention, a method for orienting a power receiving coil of a vehicle relative to a power emitting coil of a wireless charging system for a vehicle, is provided. The method comprises:
- detecting a positioning of the vehicle at a charging location in which the power receiving coil detects reception of electromagnetic radiation emitted from the power emitting coil,
- performing a calibration sequence in which the orientation of the power receiving coil and/or the power emitting coil is varied according to a predetermined scheme, while registering the electromagnetic radiation reception of the power receiving coil,
- in response to the calibrations sequence, determining a desired relative orientation including relative angle between the power receiving coil and the power emitting coil for which the electromagnetic radiation reception of the power receiving coil is in a top range of the registered electromagnetic radiation reception,
- positioning the power receiving coil relative to the power emitting coil according to the desired relative orientation.

Hereby, a simple yet effective method for determining the desired relative orientation and corresponding relative angle between the power receiving coil and the power emitting coil for which the electromagnetic radiation reception of the power receiving coil is in a top range of the registered electromagnetic radiation reception is provided. Thus, the orientation of the power receiving coil and the orientation of the power emitting coil mean that the power receiving coil is oriented, or arranged, relative to the power emitting coil with a relative angle. Thus, by performing a calibration sequence for which the orientation of the power receiving coil and/or the power emitting coil is varied according to a predetermined scheme, the relative angle for which the electromagnetic radiation reception of the power receiving coil is in a top range of the registered electromagnetic radiation reception may be determined. Thus, local maximums of the registered electromagnetic radiation reception may be avoided. During the calibration sequence, the registered electromagnetic radiation reception of the power receiving coil will typically vary between relatively low electromagnetic radiation reception and relatively high electromagnetic radiation reception depending at least on the relative orientation including relative angle between the power receiving coil and the power emitting coil. In other words, a range of different electromagnetic radiation receptions will be registered, from a bottom range comprising the relatively lowest electromagnetic radiation reception values to a top range comprising the relatively highest electromagnetic radiation reception values. By relating the electromagnetic radiation reception of the power receiving coil to be in a top range of the registered electromagnetic radiation reception, an efficient means for quickly determine a desired relative orientation including relative angle between the power receiving coil and the power emitting coil is provided without necessarily finding the relative orientation between the power receiving coil and the power emitting coil resulting in the theoretically maximum electromagnetic radiation reception. Thus, the calibration sequence with subsequent positioning can be carried out relatively quickly.

According to at least one example embodiment, the top range is the top 5 %, or the top 10 %, or the top 15 %, or the top 25 % or the top 50 % of the registered electromagnetic radiation receptions. Thus, the desired relative orientation including relative angle between the power receiving coil and the power emitting coil may be any desired relative orientation resulting in such top range. According to at least one example embodiment, the desired relative orientation between the power receiving coil and the power emitting coil corresponds to the top value, or maximum value, of the registered electromagnetic radiation reception.

According to at least one example embodiment, registering the electromagnetic radiation reception of the power receiving coil may comprise registering the efficiency of the electromagnetic radiation reception of the power receiving coil. Thus, the top range of the registered electromagnetic radiation reception may refer to the top range of the efficiency of the electromagnetic radiation reception of the power receiving coil. The efficiency of the electromagnetic radiation reception is typically a ratio of the received electromagnetic radiation of the power receiving coil to the emitted electromagnetic radiation of the power emitting coil.

According to at least one example embodiment, the top range is limited by a threshold of the registered electromagnetic radiation reception of the power receiving coil or a threshold of the efficiency of the electromagnetic radiation reception. The threshold may e.g. correspond to a lowest acceptable limit of the registered electromagnetic radiation reception or efficiency of the electromagnetic radiation reception, respectively.

According to at least one example embodiment, the predetermined scheme comprises a plurality of different orientations of the power receiving coil and/or of the power emitting coil. That is, the predetermined scheme corresponds to a plurality of different relative orientations of the power receiving coil and the power emitting coil. The plurality may e.g. be more than two, or more than three, or more than five, or more than ten different orientations of the power receiving coil and/or the power emitting coil. Thus, the calibration sequence comprises arranging the power receiving coil and/or of the power emitting coil in accordance with such plurality of different orientations over a pre-determined time span. Hereby, the orientation of the power receiving coil and/or the power emitting coil is varied in a pre-determined manner over a pre-determined time span.

According to at least one example embodiment, the predetermined scheme comprises variations of the relative angle between the power receiving coil and the power emitting coil, and the calibration sequence comprises tilting or rotating at least one of the power receiving coil and the power emitting coil in response to such predetermined scheme.

In other words, the calibration sequence is performed by varying at least the relative angle between the power receiving coil and/or the power emitting coil by tilting at least one of the power receiving coil and the power emitting coil.

According to at least one example embodiment, performing a calibration sequence comprises varying the relative angle between the power receiving coil and the power emitting coil by means of tilting or rotating the power receiving coil relative to the power emitting coil in at least the vertical direction or in a vertical plane. That is, tilting or rotating the power receiving coil relative to the power emitting coil about a geometrical axis extending perpendicular to the vertical direction. Additionality or alternatively, performing a calibration sequence comprises varying the relative angle between the power receiving coil and the power emitting coil by means of tilting or rotating the power receiving coil relative to the power emitting coil in at least the horizontal direction, or in a horizontal plane. That is, tilting or rotating the power receiving coil relative to the power emitting coil about a geometrical axis extending in the vertical direction.

According to at least one example embodiment, the predetermined scheme comprises variations of the relative angle between the power receiving coil and the power emitting coil in at least two directions.

Hereby, the desired relative orientation and relative angle between the power receiving coil and the power emitting coil are improved as it includes at least two directions. Typically, the at least two directions are perpendicular directions. For example, in a Cartesian coordinate system with three axis that are pair-wise perpendicular, wherein the axis are denoted x-axis, y-axis and z-axis, the z-axis being in the vertical direction, the at least two directions are directions in at least two of the x-axis, y-axis and z-axis. According to at least one example embodiment, the predetermined scheme comprises variations of the relative angle between the power receiving coil and the power emitting coil in the three directions. Typically, the three directions are perpendicular directions. For example, in a Cartesian coordinate system with three axis that are pair-wise perpendicular, the three directions are the three directions in the x-axis, y-axis and z-axis.

According to at least one example embodiment, the predetermined scheme comprises variations of the relative angle between the power receiving coil and the power emitting coil in at least two dimensions, or in three dimensions.

According to at least one example embodiment, the predefined scheme comprises variations of the inclination of the power receiving coil relative to a first reference frame, and the calibration sequence comprises using the vehicle suspension system to achieve such variations of the inclination of the power receiving coil.

In other words, the vehicle suspension system is used for tilting the power receiving coil relative to the first reference frame. The vehicle suspension system may e.g. be used to vary the suspension of the wheels, and thereby adjusting the distance of an undercarriage of the vehicle and the ground at which the vehicle is parked. By adjusting the suspension of the wheels differently, e.g. differently between the wheels at the front of vehicle and wheels at the back of the vehicle, or differently between the wheels at one side of the vehicle compared to an opposite side of the vehicle, the undercarriage of the vehicle, and hence the power receiving coil being attached to the undercarriage of the vehicle, may be tilted. Stated differently, the vehicle suspension system may be used to first lower one, or two of the wheels at one side of the vehicle, and then lower another one, or two of the wheels at an opposite side of the vehicle, and possibly continue with such procedure for different levels of the suspension of the wheels. Hereby, the power receiving coil will be oriented differently corresponding to the suspension level of the wheels, i.e. which wheels that are lowered, and how much they are lowered. Thus, the orientation of the power receiving coil is varied by varying the inclination of the power receiving coil relative to the first reference frame. That is, the method comprising using the vehicle suspension to at least partly perform the calibration sequence. For at least this embodiment, the power receiving coil is arranged, or attached, to the undercarriage of the vehicle such that it is inclined relative to the first reference frame together with the undercarriage of the vehicle, the first reference frame being defined externally of the vehicle. For example, the first reference frame is the road at which the vehicle is parked, or the power emitting coil of the wireless charging system. The reference frame may e.g. be a plane, such as an xy-plane in a Cartesian coordinate system.

According to at least one example embodiment, variations of the inclination of the power receiving coil is achieved by something else than the vehicle suspension system. Thus, according to at least one example embodiment, the predefined scheme comprises variations of the inclination of the power receiving coil relative to the first reference frame, and the calibration sequence comprises varying the orientation of the power receiving coil to achieve such variations of the inclination of the power receiving coil. That is, the power receiving coil may be re-oriented according to the predefined scheme.

According to at least one example embodiment, the predefined scheme comprises variations of the inclination of the power emitting coil relative to a second reference frame, and the calibration sequence comprises pivoting the power emitting coil around a pivot point to achieve such variations of the inclination of the power emitting coil.

In other words, the pivot point is used for tilting or rotating the power emitting coil relative to the second reference frame. The pivot point may e.g. be used to vary the inclination between the power emitting coil and the second reference frame in at least two directions, or in three directions, the directions being e.g. perpendicular directions in a Cartesian coordinate system, i.e. directions in the x-axis, y-axis and z-axis. Hereby, the power emitting coil will be oriented differently corresponding to how the power emitting coil is tilted in relation to the pivot point. Thus, the orientation of the power emitting coil is varied by varying the inclination of the power emitting coil relative to the second reference frame. That is, the method comprising using the pivot point to at least partly perform the calibration sequence. For at least this embodiment, the power emitting coil is arranged, or attached, to the pivot point such that it is inclined relative to the second reference frame, the second reference frame being defined externally of the vehicle. The tilting of the power emitting coil about the pivot point may be achieved by actuators or by a rotatable pivot point. For example, the power emitting coil is arranged to move around the pivot point with an integrated actuator arrangement. The second reference frame may be the same as the first reference frame. The second reference frame may e.g. be the road at which the vehicle is parked. The second reference frame may e.g. be a plane, such as an xy-plane in a Cartesian coordinate system.

According to at least one example embodiment, positioning the power receiving coil of the vehicle relative to the power emitting coil of the wireless charging system according to the desired relative orientation is performed subsequent to performing the calibration sequence and determining the desired relative orientation between the power receiving coil and the power emitting coil.

Hereby, the calibration sequence is finalized prior to positioning the power receiving coil of the vehicle relative to the power emitting coil of the wireless charging system according to the desired relative orientation. Thus, it is first determined which desired relative orientation between the power receiving coil and the power emitting coil for which the electromagnetic radiation reception of the power receiving coil is in a top range of the registered electromagnetic radiation reception, and then the positioning of the power receiving coil of the vehicle relative to the power emitting coil of the wireless charging system according to the desired relative orientation is performed.

According to at least one example embodiment, the calibration sequence is performed to include a global maximum of the electromagnetic radiation reception of the power receiving coil with regards to the relative angle between the power receiving coil and the power emitting coil.

Thus, local maximum of the electromagnetic radiation reception can be avoided. Thus, by first performing the calibration sequence, a plurality of registered electromagnetic radiation reception corresponding to the relative angle between the power receiving coil and the power emitting coil is determined. Then, the desired relative orientation including the relative angle between the power receiving coil and the power emitting coil for which the electromagnetic radiation reception of the power receiving coil is in a top range of the registered electromagnetic radiation reception is determined as a global maximum (or global top range). Such desired relative orientation including the relative angle between the power receiving coil and the power emitting coil for which the electromagnetic radiation reception of the power receiving coil is in a top range may be referred to as the sweet spot, or charging sweet spot.

According to at least one example embodiment, the method further comprises holding the power receiving coil in the desired relative orientation as a fixed position relative to the power emitting coil for charging the vehicle.

Hereby, the desired relative orientation can be kept during charging by the wireless charging system, improving the transferred electromagnetic radiation. Thus, the reached efficiency of the electromagnetic radiation reception can be maintained during the transmission of the electromagnetic radiation.

According to at least one example embodiment, the power receiving coil is a planar coil. According to at least one example embodiment, the power emitting coil is a planar coil. A planar coil typically mainly extends in a planar direction, e.g. in a horizontal plane, or in an xy-plane.

According to a second aspect of the invention, a wireless power supply device for a vehicle is provided. The wireless power supply device comprises:
- a power receiving coil for a vehicle being configured to receive electromagnetic radiation emitted from a power emitting coil of a wireless charging system,
- a positioning arrangement configured to orient the power receiving coil relative to the power emitting coil;
- a control unit connected to the positioning arrangement, the control unit being configured to control a calibration sequence in which the orientation of the power receiving coil relative the power emitting coil is varied according to a predetermined scheme by means of the positioning arrangement, while registering the electromagnetic radiation reception of the power receiving coil,
wherein the control unit is further configured to, in response to the calibration sequence, determine a desired relative orientation including relative angle between the power receiving coil and the power emitting coil for which the electromagnetic radiation reception of the power receiving coil is in a top range of the registered electromagnetic radiation reception, and to, by means of the positioning arrangement, position the power receiving coil relative to the power emitting coil according to the desired relative orientation.

Effects and features of the second aspect of the invention are largely analogous to those described above in connection with the first aspect of the invention. Embodiments mentioned in relation to the first aspect of the invention are largely compatible with the second aspect of the invention, of which some are exemplified below, typically without repetition of any advantageous effects. The wireless power supply device may e.g. be integrated in the vehicle.

For example, the vehicle may park at a charging spot such that the power receiving coil is within, or not within, an electromagnetic radiation reception distance of the power emitting coil. If the power receiving coil is not within this distance, the vehicle may be instructed to move. Alternatively, the control unit is configured to instruct repositioning of the power receiving coil (horizontally or vertically) in order to examine if such movement will bring the power receiving coil to be within an electromagnetic radiation reception distance from the power emitting coil.

According to at least one example embodiment, the positioning arrangement is configured to tilt the power receiving coil relative to the power emitting coil in order to vary the relative angle between the power receiving coil and the power emitting coil.

The predetermined scheme may comprise variations of the relative angle between the power receiving coil and the power emitting coil, and the calibration sequence may comprise instructions of tilting, by means of the positioning arrangement, at least one of the power receiving coil and the power emitting coil in response to such predetermined scheme. According to at least one example embodiment, the control unit is configured to perform the calibration sequence as described in accordance with the first aspect of the invention.

According to at least one example embodiment, the positioning arrangement comprises the vehicle suspension system to achieve variations of the inclination of the power receiving coil relative to the power emitting coil.

Thus, the control unit and the positioning arrangement are configured to perform the calibration sequence using the vehicle suspension system as described in accordance with the first aspect of the invention. For example, for embodiments in which the predefined scheme comprises variations of the inclination of the power receiving coil relative to the first reference frame, and the calibration sequence comprises using the vehicle suspension system to achieve such variations of the inclination of the power receiving coil, the control unit and the positioning arrangement are configured to carry out such calibration sequence.

According to at least one example embodiment, the control unit is configured to determine whether or not the power receiving coil is within an electromagnetic radiation reception distance from the power emitting coil.

Hereby, a criteria for initiating the calibration sequence is provided.

According to a third aspect of the invention, a wireless charging system for a vehicle is provided. The wireless charging system comprises
- a power emitting coil and a wireless power supply device according to the second aspect of the invention, the power receiving coil of the wireless power supply device being configured to receive electromagnetic radiation emitted from the power emitting coil.

Effects and features of the third aspect of the invention are largely analogous to those described above in connection with the first and second aspects of the invention. Embodiments mentioned in relation to the first and second aspects of the invention are largely compatible with the third aspect of the invention, of which some are exemplified below.

For example, the power emitting coil is configured to pivot around a pivot point to achieve variations of the inclination of the power emitting coil relative to the power emitting coil.

According to fourth aspect of the invention, a vehicle comprising a wireless power supply device according to the second aspect of the invention is provided.

According a fifth aspect of the present invention, a computer program is provided. The computer program comprises program code means for performing the method of the first aspect of the invention, when the program is run on a computer.

Such computer program may e.g. be implemented in a control unit, such as an ECU of the vehicle, e.g. the control unit according to the third aspect of the invention.

According to a sixth aspect of the present invention, a computer readable medium carrying a computer program comprising program code means for performing the method of the first aspect of the invention, when the program is run on a computer, is provided.

Effects and features of the third to sixth aspects of the invention are largely analogous to those described above in connection with the first and second aspects of the invention. Embodiments mentioned in relation to the first and second aspects of the invention are largely compatible with the third to sixth aspects of the invention.

The order of the method steps described in the present disclosure is not constrained to that described in the first aspect of the invention. One or several of the steps could switch places, or occur in a different order without departing from the scope of the invention. However, according to at least one example embodiment, the method steps are performed in the consecutive order described in the first aspect of the invention.

Further advantages and features of the present disclosure are disclosed and discussed in the following description and the accompanying drawings.

### BRIEF DESCRIPTION OF THE DRAWINGS

With reference to the appended drawings, below follows a more detailed description of embodiments of the invention cited as examples. In the drawings:
Fig. 1 is a side schematic view of a vehicle in accordance with an example embodiment of the invention;
Figs. 2A-2C are schematic perspective views of wireless charging system comprising a power emitting coil and a wireless power supply device including a power receiving coil configured to receive electromagnetic radiation emitted from the power emitting coil in accordance with an example embodiment of the invention;
Figs. 3A-3C are schematic perspective views of yet another wireless charging system comprising a power emitting coil and a power receiving coil in accordance with an example embodiment of the invention;
Fig. 4A is a perspective view of a wireless power supply device including a power receiving coil configured to receive electromagnetic radiation emitted from the power emitting coil in accordance with an example embodiment of the invention;
Fig. 4B is a perspective view of yet another wireless charging system comprising a power emitting coil and a power receiving coil in accordance with an example embodiment of the invention; and
Fig. 5 is a flowchart illustrating the steps of method in accordance with one example embodiment of the invention.

### DETAILED DESCRIPTION OF EXAMPLE EMBODIMENTS OF THE INVENTION

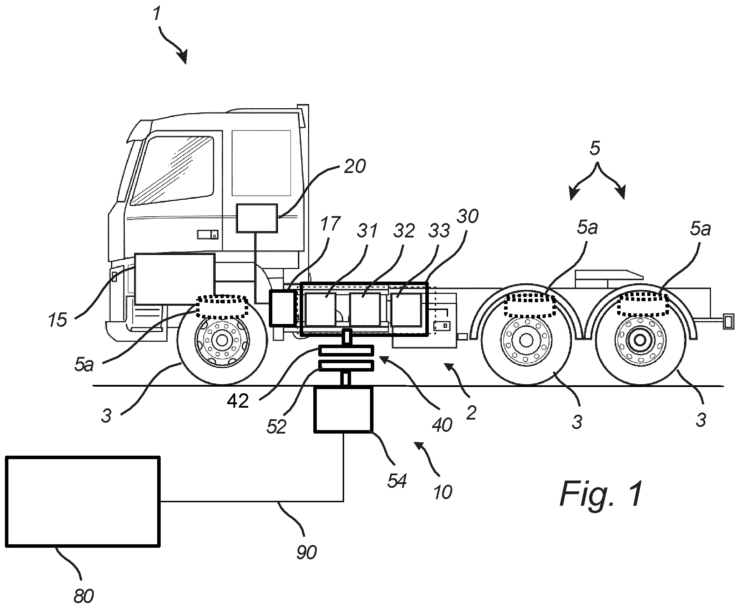

With reference to Fig. 1, a vehicle 1, here embodied as a heavy duty truck 1, is disclosed for which a method, a wireless charging system 10, and/or a wireless power supply device 40 of a kind disclosed in the present invention are advantageous. However, the method, wireless charging system 10, or a wireless power supply device 40 may as well be implemented in other types of vehicles, such as in busses, lightweight trucks, passenger cars, marine applications (e.g. in a vessel) etc. The vehicle 1 is an electric vehicle, such as a full electric vehicle or a hybrid, comprising at least one electric machine 15, a rechargeable energy storage system, RESS, 30 comprising three energy storage devices 31, 32, 33, typically batteries, the RESS 30 being arranged and configured to power the electric machine 15. Moreover, the vehicle 1 comprises an auxiliary load 20 arranged and configured for being powered by the RESS 30, the auxiliary load 20 being e.g. a heater or a HVAC system. Thus, the RESS 30 is arranged and configured to supply at least two different loads 15, 20 with electric power. The vehicle 1 further comprises an undercarriage 2 comprising the underside of the vehicle 1, wheels 3 suspended by a vehicle suspension system 5, here indicated by a separate suspension units 5a for each wheel 3. The vehicle suspension system is configured to allow relative motion between the vehicle 1 (and undercarriage 2) and the wheels 3 of the vehicle 1. The vehicle 1 typically further comprises other parts of the powertrain such as transmission and drive shafts (not shown in detail).

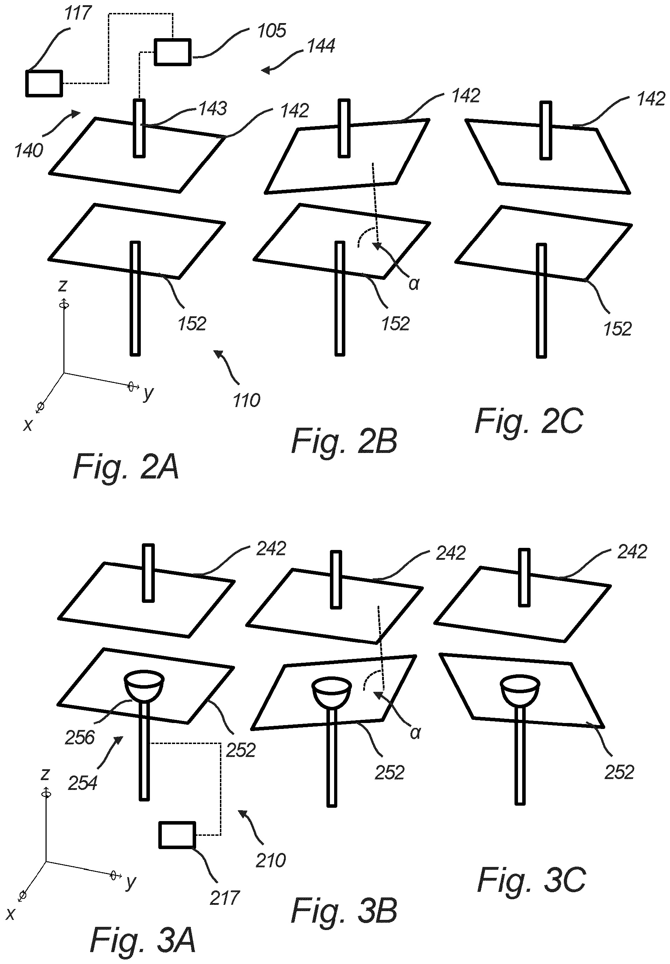

As seen in Fig. 1, the RESS 30 is connected to an electrical energy source, here being a power grid, or grid 80, via a wireless charging system 10. The wireless charging system 10 comprises a wireless power supply device 40 including at least a power receiving coil 42, and comprises a power emitting coil 52, the power receiving coil 42 being configured to receive electromagnetic radiation emitted from the power emitting coil 52. In more detail, the power emitting coil 52 is configured to emit electromagnetic radiation, and the power receiving coil 42 is configured to receive electromagnetic radiation emitted from the power emitting coil 52. The electromagnetic radiation may typically refer to the electromagnetic field induced by the power emitting coil 52, which electromagnetic field the power receiving coil 42 can utilize for power/current generation. Typically, for such power transmission to occur, the power receiving coil 42 must be within an electromagnetic radiation reception distance from the power emitting coil 52. The wireless charging system 10 may be referred to as an inductive charging system. The power receiving coil 42 and the power emitting coil 52 will be further described with reference to Figs. 2-4.

In Fig. 1, the power emitting coil 52 is powered by the grid 80 via an energy transfer means 90, typically a cable for transferring electrical energy to the power emitting coil 52 via an inlet box 54. Thus, the wireless charging system 10 is configured to charge the energy storage devices 31, 32, 33, or batteries 31, 32, 33. The vehicle 1 further comprises a control unit 17 configured to control a calibration sequence of the power receiving coil 42 relative to the power emitting coil 52 of the wireless charging system 10, as will be described in the following.

Turning to Figs. 2A-2C illustrating schematic views of a wireless charging system 110, e.g. being implemented as the wireless charging system 10 of vehicle 1 in Fig. 1. The wireless charging system 110 comprises a power emitting coil 152 and a wireless power supply device 140 including at least a power receiving coil 142, the power receiving coil 142 of being configured to receive electromagnetic radiation emitted from the power emitting coil 152. The wireless power supply device 140 is partly schematically illustrated and comprises a control unit 117 and a positioning arrangement 144 (only shown in Fig. 2A, but implicitly included in Figs. 2B-2C). The positioning arrangement 144 of Fig. 2A comprises at least the vehicle suspension system 105, such as e.g. the vehicle suspension system 5 of vehicle 1 of Fig. 1. The power receiving coil 142, here embodied as a planar power receiving coil 142, is attached to the undercarriage of the vehicle by means of an attachment means 143. For example, the attachments means 143, e.g. being a fastener or a connecting rod, is providing a fixed attachment to the undercarriage of the vehicle. Thus, the power receiving coil 142 is movable together with the attachment means 143 and the undercarriage of the vehicle.

The positioning arrangement 144 is configured to orient the power receiving coil 142 relative to the power emitting coil 152. Thus, the positioning arrangement 144 may further be considered to comprise the attachments means 143. In Fig. 2A, the relative orientation of the power receiving coil 142 and the power emitting coil 152 is controlled by the control unit 117 connected to the positioning arrangement 144, or rather the vehicle suspension system 105. The control unit 117 is configured to control a calibration sequence in which the orientation of the power receiving coil 142 is varied according to a predetermined scheme by means of the positioning arrangement 144. Thus, the vehicle suspension system 105 may achieve such variations of the orientation of the power receiving coil 142 as the attachments means 143 is attached to the undercarriage of the vehicle. In other words, the vehicle suspension system is used for tilting the power receiving coil 142 relative to a first reference frame, the first reference frame being e.g. the power emitting coil 152 (but may as well be a reference frame of the ground at which the vehicle is parked). The reference frame may e.g. be a plane, such as an xy-plane in a Cartesian coordinate system. Thus, the vehicle suspension system 105 may be used to vary the suspension of the wheels, and thereby adjusting the distance of the undercarriage and the ground at which the vehicle is parked. By adjusting the suspension of the wheels differently, e.g. differently between the wheels at the front of vehicle and wheels at the back of the vehicle, or differently between the wheels at one side of the vehicle compared to an opposite side of the vehicle, the undercarriage of the vehicle, and hence the power receiving coil 142, may be tilted. Hereby, the power receiving coil 142 will be oriented differently corresponding to the level of the suspension of the vehicle. Thus, the orientation of the power receiving coil 142 is varied by varying the inclination of the power receiving coil 142 relative to the first reference frame, as can be seen in Figs 2B and 2C. Stated differently, the positioning arrangement 144 is configured to tilt or rotate the power receiving coil 142 relative to the power emitting coil 152 in order to vary the relative angle α between the power receiving coil 142 and the power emitting coil 152 (only shown in Fig. 2B). That is, the vehicle suspension 105 is used to achieve variations of the inclination of the power receiving coil 142 relative to the power emitting coil 152, and thereby at least partly perform the calibration sequence. Thus, the predefined scheme comprises variations of the inclination of the power receiving coil 142 relative to the first reference frame, and the calibration sequence comprises using the vehicle suspension system 105 to achieve such variations of the inclination of the power receiving coil 142. According to at least one example embodiment, the orientation of the power emitting coil 152 is fixed in Figs. 2A-2C, and/or the power emitting coil 152 lacks the functionality of varying its orientation.

During the calibration sequence, the control unit 117 is configured to register the electromagnetic radiation reception of the power receiving coil 142. The control unit 117 is further configured to, in response to the calibration sequence, determine a desired relative orientation including relative angle α between the power receiving coil 142 and the power emitting coil 152 for which the electromagnetic radiation reception of the power receiving coil 142 is in a top range of the registered electromagnetic radiation reception, and to, by means of the positioning arrangement 144 (i.e. here being the vehicle suspension system 105 and the attachment means 143), position the power receiving coil 142 relative to the power emitting coil 152 according to the desired relative orientation. Moreover, the control unit 117 may be configured to determine whether or not the power receiving coil 142 is within an electromagnetic radiation reception distance from the power emitting coil 152, prior to performing the calibration sequence.

Turning to Figs. 3A-3C, illustrating schematic views of a wireless charging system 210, e.g. being implemented as the wireless charging system 10 of vehicle 1 in Fig. 1. The wireless charging system 210 comprises a power receiving coil 242, e.g. the same as the power receiving coil 142 of Figs. 2A-2C, and a power emitting coil 252. However, according to at least one example embodiment, the orientation of the power receiving coil 242 is fixed in Figs. 3A-3C, and/or the power receiving coil 242 lacks the functionality of varying its orientation. The power emitting coil 252 is e.g. a planar power emitting coil 252. The power receiving coil 242 is configured to receive electromagnetic radiation emitted from the power emitting coil 252. Instead of varying the orientation of the power receiving coil 142, 242 as described with reference to Figs. 2A-2C, the orientation of the power emitting coil 252 is varied in Figs. 3A-3C. However, the configuration and embodiment of the wireless power supply device 140 and the power receiving coil 142 of Figs. 2A-2C may according to at least one example embodiment be combined with the embodiment of Figs. 3A-3C. In Fig. 3A, the wireless charging system 210 is partly schematically illustrated and comprises a control unit 217 (only shown in Fig. 3A, but implicitly included in the Figs. 3B-3C) and a positioning arrangement 254 The positioning arrangement 254 of Fig. 3A comprises a rotatable pivot point 256 being pivotally attached to the power emitting coil 252, and used for tilting or rotating the power emitting coil 252 relative to a second reference frame. The second reference frame may e.g. be a reference frame of the ground at which the vehicle is parked. The second reference frame may e.g. be a plane, such as an xy-plane in a Cartesian coordinate system. Thus, corresponding to the predefined scheme and the calibration sequence described with reference to Figs. 2A-2C, the predefined scheme may comprises variations of the inclination of the power emitting coil 252 relative to the second reference frame, and the calibration sequence may comprise pivoting the power emitting coil 252 around the rotatable pivot point 256 to achieve such variations of the inclination of the power emitting coil 252. In more detail, the rotatable pivot point 256 may be used to vary the inclination between the power emitting coil 252 and the second reference frame in at least two directions, or in three directions, the directions being e.g. perpendicular directions in a Cartesian coordinate system, i.e. directions in the x-axis, y-axis and z-axis. Hereby, the power emitting coil 252 can be oriented differently corresponding to how the power emitting coil 252 is tilted or rotated in relation to the rotatable pivot point 256, as shown in Figs. 3B and 3C. Thus, the orientation of the power emitting coil 252 is varied by varying the inclination of the power emitting coil 252 relative to the second reference frame. That is, the rotatable pivot point 256 is used to at least partly perform the calibration sequence. As seen in Figs. 3A-3B, the power emitting coil 252 is arranged, or attached, to the rotatable pivot point 256 such that it can be inclined relative to the second reference frame.

Correspondingly to the control unit 117 of Fig. 2A, the control unit 217 of Fig. 3A is configured to register the electromagnetic radiation reception of the power receiving coil 242 (this may e.g. be achieved by that the electromagnetic radiation reception of the power receiving coil 242 is wirelessly transferred to the control unit 217). The control unit 217 is further configured to, in response to the calibration sequence, determine a desired relative orientation including relative angle α (only shown in Fig. 3B) between the power receiving coil 242 and the power emitting coil 252 for which the electromagnetic radiation reception of the power receiving coil 242 is in a top range of the registered electromagnetic radiation reception, and to, by means of the positioning arrangement 254 (i.e. here being rotatable pivot point 256 and/or any integrated actuators used to control it), position the power emitting coil 252 relative to the power receiving coil 242 according to the desired relative orientation. Moreover, the control unit 217 may be configured to determine whether or not the power receiving coil 242 is within an electromagnetic radiation reception distance from the power emitting coil 252, prior to performing the calibration sequence.

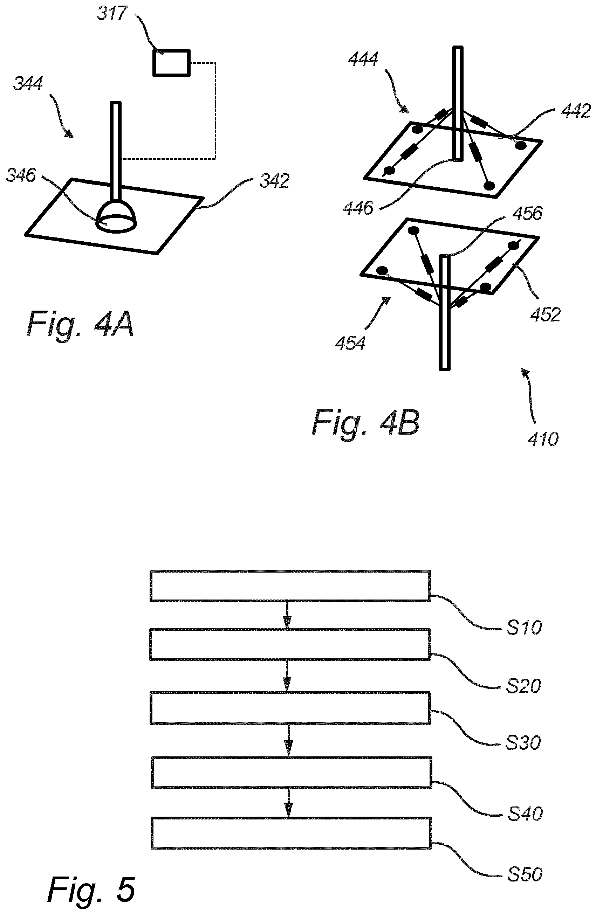

Instead of varying the orientation of the power emitting coil 252 with the positioning arrangement 254 comprising a rotatable pivot point 256 as in Fig. 3A, the orientation of the power receiving coil may be varied by means of such positioning arrangement as shown in Fig. 4A. Here, the positioning arrangement 344 comprises a corresponding rotatable pivot point 346 being pivotally attached to the power receiving coil 342. The positioning arrangement 344 and the rotatable pivot point 346 are thus used for tilting or rotating the power receiving coil 342 relative to the first reference frame, e.g. by being instructed to do so in a calibration sequence by the control unit 317. Thus, the function thereof corresponds to that described with reference to Figs. 3A-3C and is not repeated here again.

Another embodiment of a wireless charging system 410 is shown in Fig 4B. The wireless charging system 410 comprises a power receiving coil 442 and a power emitting coil 452, e.g. being planar coils 442, 452. The power receiving coil 442 is configured to receive electromagnetic radiation emitted from the power emitting coil 452. In Fig. 4B both the power receiving coil 442 and a power emitting coil 452 are configured to vary the orientation of the power receiving coil 442 and a power emitting coil 452, respectively, by means of actuators 444, 454. The actuators 444, 454 are configured to tilt or rotate the power receiving coil 442 and a power emitting coil 452, respectively about a fixed pivot point 446, 456, respectively. For example, the power emitting coil 452 is arranged to move around the fixed pivot point 456 by means of the actuators 454 connected to the power emitting coil 452. Correspondingly, the power receiving coil 442 is arranged to move around the fixed pivot point 446 by means of the actuators 444 connected to the power receiving coil 442. Thus, the orientation of the power emitting coil 452 may be varied by varying the inclination of the power emitting coil 452 relative to the second reference frame, as described with reference to Figs 3A-3C, and the orientation of the power receiving coil 442 may be varied by varying the inclination of the power receiving coil 442 relative to the first reference frame, as described with reference to Figs 2A-2C. As for the earlier described embodiments, a control unit may be configured to perform a calibration sequence for varying the relative orientation of the power receiving coil 442 and the power emitting coil 452. Such control unit is then typically further configured to, in response to the calibration sequence, determine a desired relative orientation including relative angle between the power receiving coil 442 and the power emitting coil 452 for which the electromagnetic radiation reception of the power receiving coil 442 is in a top range of the registered electromagnetic radiation reception, and to, by means of the positioning arrangement (i.e. here being actuators 444, 454), position the power emitting coil 452 relative to the power receiving coil 442 according to the desired relative orientation.

However, it should be noted that only one of the power receiving coil 442 and the power emitting coil 452 may be controlled to vary its orientation as described with reference to Fig. 4B. Thus, the power receiving coil in the wireless charging system 410 may e.g. be the same as the power receiving coil 142 of Figs. 2A-2C, or the power receiving coil 242 of Figs. 3A-3C, or the power emitting coil in the wireless charging system 410 may e.g. be the same as the power emitting coil 152 of Figs. 2A-2C, or the power emitting coil 252 of Figs. 3A-3C.

Turning to the flowchart of Fig. 5, schematically illustrating steps for orienting a power receiving coil of a vehicle relative to a power emitting coil of a wireless charging system for a vehicle, such as the power receiving coils and power emitting coils described with reference to Figs. 1-4B.

In a first step S10, a positioning of the vehicle at a charging location in which the power receiving coil detects reception of electromagnetic radiation emitted from the power emitting coil is detected.

At, or during, the first step S10, the power receiving coil is distanced from the power emitting coil by at least a first vertical distance d1. Depending on the efficiency of the electromagnetic radiation reception at the first vertical distance d1, the power receiving coil may be repositioned relative the power emitting coil in at least the vertical direction. After such repositioning, the power receiving coil is typically distanced from the power emitting coil by at least a second vertical distance d2, the second vertical distance d2 being smaller than the first vertical distance d1. Such movement in the at least vertical direction may e.g. be a movement in the vertical direction (parallel to the gravitational direction, i.e. either in the gravitational direction or opposite the gravitational direction).

In a second step S20, a calibration sequence in which the orientation of the power receiving coil and/or the power emitting coil is varied according to a predetermined scheme, while registering the electromagnetic radiation reception of the power receiving coil, is performed. The predetermined scheme typically comprises a plurality of different orientations of the power receiving coil and/or the power emitting coil. For example, the predetermined scheme comprises variations of the relative angle between the power receiving coil and the power emitting coil, and the calibration sequence comprises tilting or rotating at least one of the power receiving coil and the power emitting coil in response to such predetermined scheme, as described with reference to Figs. 2A-4B. The predetermined scheme may thus comprise variations of the relative angle between the power receiving coil and the power emitting in at least two directions, e.g. in three directions. Moreover, the predefined scheme may comprise variations of the inclination of the power receiving coil relative to a first reference frame. Additionally, the calibration sequence may comprise using the vehicle suspension system to achieve such variations of the inclination of the power receiving coil, as for example described with reference to Figs. 2A-2C. Additionally, or alternatively, the predefined scheme may comprise variations of the inclination of the power emitting coil relative to a second reference frame. Here, the calibration sequence comprises pivoting the power emitting coil around a rotatable pivot point to achieve such variations of the inclination of the power emitting coil, as for example described with reference to Figs. 3A-3C.

In a third step S30, in response to the calibrations sequence, a desired relative orientation including relative angle between the power receiving coil and the power emitting coil for which the electromagnetic radiation reception of the power receiving coil is in a top range of the registered electromagnetic radiation reception is determined

In a fourth step S40, the power receiving coil is positioned relative to the power emitting coil according to the desired relative orientation. The step S40 of positioning the power receiving coil of the vehicle relative to the power emitting coil of the wireless charging system according to the desired relative orientation is typically performed subsequent to the step S20 of performing the calibration sequence and determining the desired relative orientation between the power receiving coil and the power emitting coil. According to at least one example embodiment, the calibration sequence is performed to include a global maximum of the electromagnetic radiation reception of the power receiving coil with regards to the relative angle between the power receiving coil and the power emitting coil. Thus, the step S40 of positioning the power receiving coil of the vehicle relative to the power emitting coil of the wireless charging system according to the desired relative orientation comprises positioning the power receiving coil relative to the power emitting coil such that a global maximum of the electromagnetic radiation reception of the power receiving coil is achieved.

In a fifth step S50, the power receiving coil is held in the desired relative orientation as a fixed position relative to the power emitting coil for charging the vehicle.

It should be noted that the naming of the steps not necessarily, but might according to at least one example embodiment, relate to the order in which the steps are carried out. Thus, the order of the steps may be different than that explained here. Moreover, the control unit 17 of Fig. 1 (or any of the other control units 117, 217, 317) may be configured to carry out one or several of the steps S10-S50.

It should be noted that the control unit 17, 117, 217, 317 may instead of being on-vehicle based, be arranged off-board, e.g. on the same side as the power emitting coil. However, such configuration would typically include wireless communication with another control unit arranged on-board the vehicle 1.

It is to be understood that the present invention is not limited to the embodiments described above and illustrated in the drawings; rather, the skilled person will recognize that many changes and modifications may be made within the scope of the appended claims.

Additionally, variations to the disclosed embodiments can be understood and effected by the skilled person in practicing the claimed inventive concept, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage.

## Claims

1. A method for orienting a power receiving coil of a vehicle relative to a power emitting coil of a wireless charging system for a vehicle, the method comprising:
- detecting a positioning of the vehicle at a charging location in which the power receiving coil detects reception of electromagnetic radiation emitted from the power emitting coil,
- performing a calibration sequence in which the orientation of the power receiving coil and/or the power emitting coil is varied according to a predetermined scheme, while registering the electromagnetic radiation reception of the power receiving coil,
- in response to the calibrations sequence, determining a desired relative orientation including relative angle between the power receiving coil and the power emitting coil for which the electromagnetic radiation reception of the power receiving coil is in a top range of the registered electromagnetic radiation reception,
- positioning the power receiving coil relative to the power emitting coil according to the desired relative orientation.

2. The method according to claim 1, wherein the predetermined scheme comprises a plurality of different orientations of the power receiving coil and/or the power emitting coil.

3. The method according to any one of the preceding claims, wherein the predetermined scheme comprises variations of the relative angle between the power receiving coil and the power emitting coil, and the calibration sequence comprises tilting or rotating at least one of the power receiving coil and the power emitting coil in response to such predetermined scheme.

4. The method according to claim 3, wherein the predetermined scheme comprises variations of the relative angle between the power receiving coil and the power emitting coil in at least two directions.

5. The method according to any one of claims 3-4, wherein the predefined scheme comprises variations of the inclination of the power receiving coil relative to a first reference frame, and the calibration sequence comprises using the vehicle suspension system to achieve such variations of the inclination of the power receiving coil.

6. The method according to any one of claims 3-5, wherein the predefined scheme comprises variations of the inclination of the power emitting coil relative to a second reference frame, and the calibration sequence comprises pivoting the power emitting coil around a pivot point to achieve such variations of the inclination of the power emitting coil.

7. The method according to any one of the preceding claims, wherein positioning the power receiving coil of the vehicle relative to the power emitting coil of the wireless charging system according to the desired relative orientation is performed subsequent to performing the calibration sequence and determining the desired relative orientation between the power receiving coil and the power emitting coil.

8. The method according to any one of the preceding claims, wherein the calibration sequence is performed to include a global maximum of the electromagnetic radiation reception of the power receiving coil with regards to the relative angle between the power receiving coil and the power emitting coil.

9. The method according to any one of the preceding claims, further comprising holding the power receiving coil in the desired relative orientation as a fixed position relative to the power emitting coil for charging the vehicle.

10. A wireless power supply device (120) for a vehicle, the wireless power supply device comprising:
- a power receiving coil (122) for a vehicle being configured to receive electromagnetic radiation emitted from a power emitting coil (222) of a wireless charging system,
- a positioning arrangement (130, 230) configured to orient the power receiving coil relative to the power emitting coil;
- a control unit (3) connected to the positioning arrangement, the control unit being configured to control a calibration sequence in which the orientation of the power receiving coil and/or the power emitting coil is varied according to a predetermined scheme by means of the positioning arrangement, while registering the electromagnetic radiation reception of the power receiving coil,
wherein the control unit is further configured to, in response to the calibration sequence, determine a desired relative orientation including relative angle between the power receiving coil and the power emitting coil for which the electromagnetic radiation reception of the power receiving coil is in a top range of the registered electromagnetic radiation reception, and to, by means of the positioning arrangement, position the power receiving coil relative to the power emitting coil according to the desired relative orientation.

11. The wireless power supply device according to claim 10, wherein the positioning arrangement is configured to tilt the power receiving coil relative to the power emitting coil in order to vary the relative angle between the power receiving coil and the power emitting coil.

12. The wireless power supply device according to claim 11, wherein the positioning arrangement comprises the vehicle suspension system to achieve variations of the inclination of the power receiving coil relative to the power emitting coil.

13. A wireless charging system for a vehicle, the wireless charging system comprising:
- a power emitting coil (222) and a wireless power supply device according to any one of claims 10-12, the power receiving coil (122) of the wireless power supply device being configured to receive electromagnetic radiation emitted from the power emitting coil (222).

14. A computer program comprising program code means for performing the method of any of claims 1-9, when the program is run on a computer.

15. A vehicle (1) comprising a wireless power supply device according to any one of claims 10-12.
